# EUROPEAN PATENT APPLICATION

(11) **EP 4 485 071 A1**
(43) Date of publication of application: **01.01.2025**
(21) Application number: 23212786.0
(22) Date of filing: 28.11.2023
(51) Int. Cl.: G03F 1/38

(54) **METHODS AND APPARATUS TO PHOTOLITHOGRAPHICALLY PATTERN MATERIALS IN INTEGRATED CIRCUIT PACKAGES**

(30) Priority: 26.06.2023 US 202318341137
(71) Applicant: INTEL Corporation, Santa Clara, CA 95054 (US)
(72) Inventor: KAWADA, Sho, Ogaki-shi, 503-0025 (JP)
(74) Representative: HGF

(57) **Abstract**

Systems, apparatus, articles of manufacture, and methods to photolithographically pattern materials in integrated circuit packages are disclosed. An example photolithography mask includes: a transparent substrate, and an opaque material supported by the transparent substrate. The opaque material covers a first area of the transparent substrate. The example photolithography mask further includes an optical filter supported by the transparent substrate. The optical filter covers a second area of the transparent substrate. The second area is distinct from the first area. Both the opaque material and the optical material are spaced apart from a third area of the transparent substrate

## Description

### FIELD OF THE DISCLOSURE

This disclosure relates generally to semiconductor device fabrication and, more particularly, to methods and apparatus to photolithographically pattern materials in integrated circuit packages.

### BACKGROUND

Semiconductor device fabrication includes various processes to manufacture integrated circuits or chips. Many processes involved in semiconductor device fabrication involve the use of photolithography. Photolithography involves the application of light onto a layer of light-sensitive material (e.g., a photoresist, also sometimes referred to simply as a resist) in a controlled manner to produce a pattern in the layer of material in which portions of the layer of material are retained while other portions are removed. Depending on the particular materials and techniques involved, the retained portions may correspond to regions of the layer of material that were exposed to the light while the removed portions correspond to regions that were not exposed to the light. However, in other situations, the retained portions may correspond to the regions not exposed to the light while the removed portions correspond to the regions that were exposed to the light. Often, the exposure of light onto a photoresist is controlled through the use of a photolithography mask (e.g., a photomask or simply mask) between the light source and the photoresist.

### BRIEF DESCRIPTION OF THE DRAWINGS

FIG. 1 illustrates an example integrated circuit (IC) package constructed in accordance with teachings disclosed herein.
FIG. 2 illustrates an example system to photolithographically pattern materials in the IC package of FIG. 1.
FIG. 3 illustrates i-line light exposed onto a solder resist after passing through a photomask.
FIG. 4 illustrates h-line light exposed onto the same solder resist of FIG. 3 after passing through the same photomask of FIG. 3.
FIG. 5 shows a photomask that is aligned overtop of a solder resist after being exposed to i-line light through the photomask.
FIG. 6 shows another photomask that is aligned overtop of another solder resist after being exposed to h-line light through the photomask.
FIG. 7 is a cross-sectional side view of an example photomask constructed in accordance with teachings disclosed herein.
FIG. 8 is a bottom view of the example photomask of FIG. 7.
FIG. 9 illustrates the example photomask of FIGS. 7 and 8 being used to pattern the solder resist of FIGS. 3 and 4 with the filtered light of FIG. 2.
FIG. 10 illustrates an example photomask that is aligned overtop of a solder resist after being simultaneously exposed to both the i-line light and the h-line light through the example photomask.
FIGS. 11-19 illustrate different example photomasks constructed in accordance with teachings disclosed herein.
FIGS. 20-24 illustrate example stages in a manufacturing process to add a discrete region of opaque material to a transparent substrate for a photomask.
FIGS. 25-27 illustrate example stages in a manufacturing process to add an optical filter adjacent to the discrete region of opaque material shown in FIG. 24.
FIGS. 28-32 illustrate alternate example stages in a manufacturing process to add an optical filter adjacent to the discrete region of an opaque material such as the opaque material shown in FIG. 24.
FIGS. 33-35 are flowcharts illustrating example methods of manufacturing any of the example photomasks disclosed herein.

In general, the same reference numbers will be used throughout the drawing(s) and accompanying written description to refer to the same or like parts. The figures are not necessarily to scale. Instead, the thickness of the layers or regions may be enlarged in the drawings. Although the figures show layers and regions with clean lines and boundaries, some or all of these lines and/or boundaries may be idealized. In reality, the boundaries and/or lines may be unobservable, blended, and/or irregular.

### DETAILED DESCRIPTION

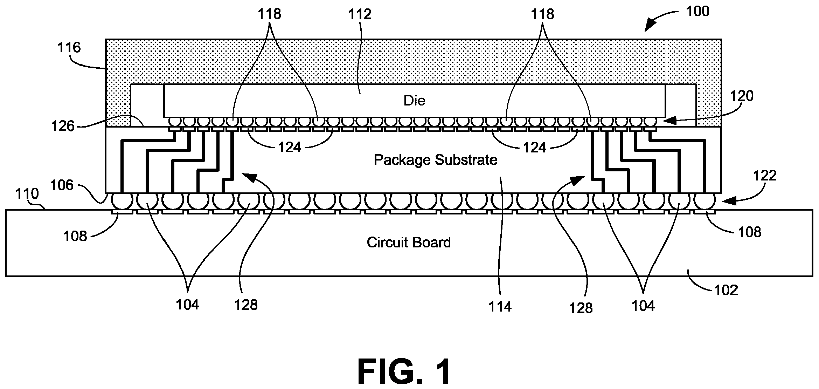

FIG. 1 illustrates an example integrated circuit (IC) package 100 constructed in accordance with teachings disclosed herein. In the illustrated example, the IC package 100 is electrically coupled to a circuit board 102 via an array of bumps or balls 104 (e.g., a ball grid array (BGA)) that protrude from a mounting surface (e.g., an external surface) 106 of the package 100. In this example, the bumps 104 are electrically coupled to corresponding contacts or landing pads 108 on a facing mounting surface (e.g., a top surface) 110 of the circuit board 102. In this example, the landing pads 108 are flush with the top surface 110 of the circuit board 102. In other examples, the landing pads 108 are inset relative to the top surface 110. In other examples, the landing pads 108 protrude beyond the top surface 110. In this example, the package 100 includes a semiconductor (e.g., silicon) die 112 that is mounted to a package substrate 114 and enclosed by a package lid or mold compound 116. While the example IC package 100 of FIG. 1 includes a single die 112, in other examples, the package 100 may have more than one die (e.g., two or more positioned side-by-side on the package substrate 114 and/or two or more stacked on top of one another). The die 112 can provide any suitable type of functionality (e.g., data processing, memory storage, etc.).

As shown in the illustrated example, the die 112 is electrically and mechanically coupled to the package substrate 114 via a corresponding array of bumps or balls 118. The electrical connections between the die 112 and the package substrate 114 (e.g., the bumps 118) are sometimes referred to as first level interconnects 120. By contrast, the electrical connections between the IC package 100 and the circuit board 102 (e.g., the bumps 104) are sometimes referred to as second level interconnects 122. In some examples, when more than one die is included in the package 100, the dies may be stacked on top of one or more other dies and/or an interposer. In such examples, the dies are coupled to the underlying die and/or interposer through a first set of first level interconnects and the underlying die and/or interposer may be connected to the package substrate 114 via a separate set of first level interconnects associated with the underlying die and/or interposer. Thus, as used herein, first level interconnects refer to bumps or balls or other types of interconnects between a die and a package substrate or a die and an underlying die and/or interposer.

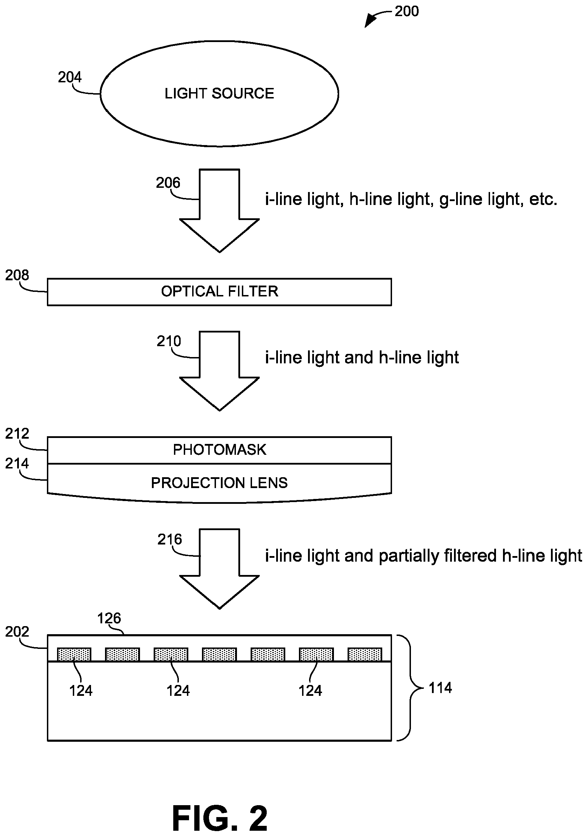

As shown in FIG. 1, the bumps 118 of the first level interconnects 120 are physically connected and electrically coupled to contact pads 124 on an inner surface 126 of the substrate 114. For purposes of illustration, the contact pads 124 are shown to be flush with the inner surface 126 of the substrate 114. However, in some examples, the contact pads 124 are inset relative to the inner surface 126. Specifically, in some such examples, the inner surface 126 is defined by a solder resist 202 shown in FIG. 2) that includes openings to expose corresponding ones of the contact pads 124. The contact pads 124 along on the inner surface 126 of the package substrate 114 are electrically coupled to the bumps 104 on the bottom (external) surface 106 of the substrate 114 (e.g., a surface opposite the inner surface 126) via internal interconnects 128 within the substrate 114. As a result, there is a complete signal path between the bumps 118 of the die 112 and the landing pads 108 on the circuit board 102 that pass through the contact pads 124, the interconnects 128, and the bumps 104 provided therebetween. The interconnects 128 are shown as simple lines in the illustrated example of FIG. 1 for purposes of illustration. However, the internal interconnects 128 may be implemented by traces or electrical routing in different metal layers within the substrate 114 that are separated by layers of dielectric material. The traces in the different metal layers are electrically coupled by metal vias extending through the layers of dielectric material.

FIG. 2 illustrates an example system 200 to photolithographically pattern materials in the IC package 100 of FIG. 1. For purposes of explanation, FIG. 2 will be described with respect to the patterning of a solder resist 202 on the inner surface 126 of the package substrate 114 of FIG. 1. However, example methods and apparatus disclosed herein can be suitably adapted to photolithographically pattern materials in other layers within the package substrate 114. Further, teachings disclosed herein can also be used to photolithographically pattern materials in the die 112.

At the stage of fabrication represented by FIG. 2, the contact pads 124 of the package substrate 114 of FIG. 1 are covered by the solder resist. Accordingly, the photolithographic process illustrated in FIG. 2 is to pattern the solder resist 202 to define openings that expose the contact pads 124 to enable the electrical and mechanical coupling with the bumps 118 on the die 112 as shown in FIG. 1.

The example system 200 of FIG. 2 includes a light source 204 that produces light 206 (e.g., unfiltered light) having a particular spectral profile. In this example, the light source 204 is a high pressure mercury lamp. The spectrum of light produced by mercury lamps include several spikes of relatively high intensity light at specific wavelengths. Different ones of the spikes of high intensity light from a mercury lamp are referred to herein as different lines including i-line light, h-line light, and g-line light. As used herein, i-line light is light having a wavelength of approximately 365 nanometers (nm), h-line light is light having a wavelength of approximately 405 nm, and g-line light is light having a wavelength of approximately 435 nm.

As shown in the illustrated example, the light 206 (e.g., unfiltered light) emanating from the light source 204 is passed through an optical filter 208 (also referred to as a cut filter) to produce filtered light 210. Many known lithography techniques employ an optical filter that filters or cuts out all light except a single particular line of light (e.g., everything except the i-line light or everything except the h-line light). Unlike these existing approaches, the optical filter 208 of FIG. 2 is constructed to permit both the i-line light and the h-line light while filtering or cutting the g-line light and other wavelengths of light.

As shown in the illustrated example, the filtered light 210 is passed through a photomask 212 (or simply mask) and a projection lens 214 to produce masked light 216 that is shone upon the solder resist 202 of the package substrate 114. Typically, a photomask includes a transparent base or substrate. In some examples, the transparent substrate is a solid piece of glass (e.g., a glass pane, panel, or sheet). In some examples, the transparent (e.g., glass) substrate includes at least one of: aluminosilicate, borosilicate, alumino-borosilicate, silica, and/or fused silica. In some examples, the transparent (e.g., glass) substrate includes one or more additives including: aluminum oxide (AI2O3), boron trioxide (B203), magnesia oxide (MgO), calcium oxide (CaO), stoichiometric silicon oxide (SrO), barium oxide (BaO), stannic oxide (SnO2), nickel alloy (Na2O), potassium oxide (K2O), phosphorus trioxide (P2O3), zirconium dioxide (ZrO2), lithium oxide (Li2O), titanium (Ti), and/or zinc (Zn). In some examples, the transparent (e.g., glass) substrate includes silicon and oxygen. In some examples, the transparent (e.g., glass) substrate includes silicon, oxygen and/or one or more of aluminum, boron, magnesium, calcium, barium, tin, sodium, potassium, strontium, phosphorus, zirconium, lithium, titanium, and/or zinc. In some examples, the transparent (e.g., glass) substrate includes at least 23 percent silicon by weight and at least 26 percent oxygen by weight. In some examples, the transparent (e.g., glass) substrate is a layer of glass including silicon, oxygen and aluminum. In some examples, the transparent (e.g., glass) substrate includes at least 23 percent silicon by weight, at least 26 percent oxygen by weight, and at least 5 percent aluminum by weight. In some examples, the transparent (e.g., glass) substrate is an amorphous solid glass layer.

In addition to a transparent (e.g., glass) substrate, photomasks typically include an opaque material that partially covers the transparent substrate at regions corresponding to a pattern to be transferred to the solder resist 202. That is, the regions corresponding to the opaque material block the filtered light 210 from reaching the solder resist 202 while the regions in which there is no opaque material permit the light to pass through and shine on the solder resist 202. The solder resist is a photo-sensitive material such that the portions of the solder resist 202 exposed to the masked light 216 will react to the light and change characteristics. Specifically, in some examples, the solder resist 202 exposed to light will harden such that when a developer solution is applied to the solder resist 202, the portions that remain relatively soft (e.g., the portions not exposed to the light) will be removed while the hardened portions will remain. In this manner the pattern defined by the opaque regions on the photomask 212 are transferred to the solder resist 202.

Known photomasks typically modify light in a binary manner by either blocking light (e.g., by the opaque material) or permitting light to pass through (e.g., at locations where there is no opaque material). Unlike known photomasks, the example photomask 212 of FIG. 2 is not binary but selectively permits certain wavelengths of light at some regions and other wavelengths of light at other regions. More particularly, as indicated by the labels in FIG. 2, the masked light 216 in the illustrated example includes the i-line light from the filtered light 210 with the h-line light being partially filtered. That is, in this example, the photomask 212 filters or blocks the h-line light at some regions while permitting the i-line light to pass through those same regions. However, there are other regions in which both the i-line light and the h-line light (e.g., all of the i-line and h-line light) are permitted to pass through the mask 212. Further, in some examples, the photomask 212 includes regions blocked by an opaque material in which neither the i-line light nor the h-line light are able to pass. Thus, the photomask 212 of the illustrated example includes first regions that permit the transmission of most (e.g., all) light and second regions that block light, in a binary manner, but the light that passes through the first regions is further divided into sub-regions in which different wavelengths of light are permitted to pass (e.g., some sub-regions permit both i-line light and h-line light while other sub-regions permit only the i-line light).

Although FIG. 2 is shown and described as partially filtering h-line light while permitting i-line light to pass through the photomask 212 at certain locations, in other examples, the h-line light is permitted everywhere there is no opaque material with the i-line light selectively filtered at certain locations at which the h-line light is permitted to pass through. Further, in some examples, both the i-line light and the h-line light may be filtered (e.g., blocked) at certain regions where other lines of light are permitted to pass through. Further, while the example shown in FIG. 2 is focused on i-line light and h-line light, teachings disclosed herein can be applied to any other wavelengths of light. For instance, in some examples, the optical filter 208 is modified to permit g-line light (or any other suitable wavelength of light) to pass through and be included in the filtered light 210. In some such examples, the photomask 212 is constructed to selectively filter the g-line light at locations where other wavelengths of light are still permitted to pass through. Further, in some examples, a different type of light source 204 may be used that emits different wavelengths of light (e.g., has a different spectral profile) than a mercury lamp discussed above. In such examples, the photomask 212 can selectively filter certain wavelengths of the light from passing through while permitting other wavelengths of light as disclosed herein. In some examples, the filtering functionality of the photomask 212 can serve the function of the optical filter 208 by entirely filtering out certain wavelengths of light while still permitting other wavelengths of light to pass through. As such, in some such examples, the optical filter 208 is omitted.

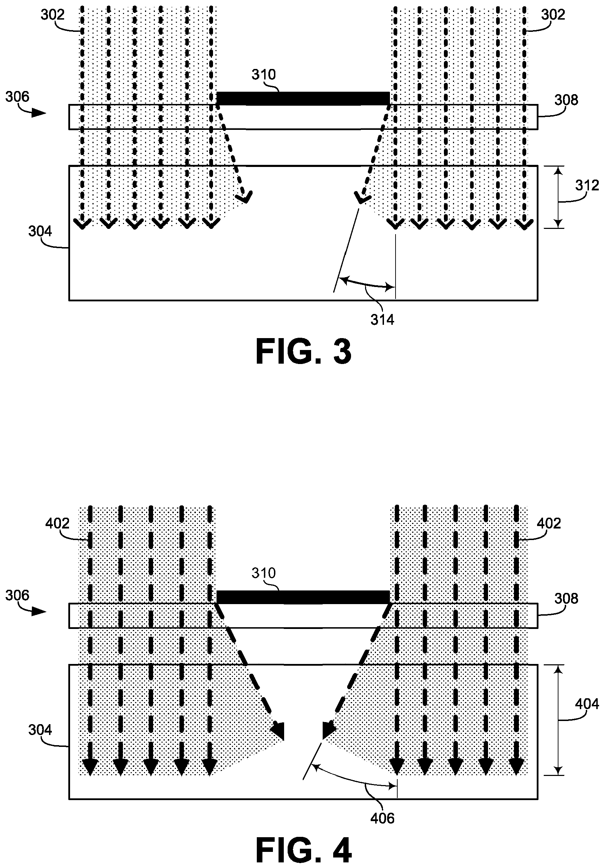

While teachings disclosed herein can be applied to any wavelengths of light, the example shown in FIG. 2, with the filtered light 210 incident on the photomask 212 including i-line light and h-line light, will be discussed in detail for purposes of explanation. I-line light and h-line light are two common wavelengths of light used in photolithography that each have benefits and drawbacks demonstrated with reference to FIGS. 3-6. FIG. 3 illustrates i-line light 302 exposed onto a solder resist 304 after passing through a photomask 306. FIG. 4 illustrates h-line light 402 exposed onto the same solder resist 304 of FIG. 3 after passing through the same photomask 306 of FIG. 3. For the purposes of illustration, the i-line light 302 is represented by light shading and arrows with short broken lines and an open chevron head. By contrast, the h-line light 402 is represented by darker shading and arrows with longer broken lines and a closed triangular head.

As shown in FIGS. 3 and 4, the photomask 306 includes a transparent base or substrate 308 that supports an opaque material 310. In many known photomasks, the transparent substrate 308 corresponds to a glass pane (e.g., a glass panel, a glass sheet) and the opaque material 310 is composed of chromium. The opaque material 310, as its name suggests, prevents or blocks the light 302, 402 incident thereon from passing through the photomask 306. However, for the sake of simplicity, the light 302, 402 incident on the opaque material 310 is not shown in FIGS. 3 and 4.

As shown by a comparison of FIGS. 3 and 4, there are two main differences between the i-line light 302 (FIG. 3) and the h-line light 402 (FIG. 4). A first difference is the depth to which the respective wavelengths of light penetrate into the solder resist 304. Specifically, the i-line light 302 has a shorter wavelength than the h-line light 402 (e.g., 365nm for i-line light as compared with 405nm for h-line light). Due to the shorter wavelength, the i-line light 302 reaches a first depth 312 that is less than a second depth 404 reached by the h-line light 402. The i-line light 302 is limited to the relatively shallow depth due to absorption and/or scattering of the relatively short wavelengths of light by the solder resist 304. The second difference between the i-line light 302 and the h-line light 402, which is also based on the different wavelengths, is the diffraction angle of the light at the edge of the opaque material 310. As illustrated in FIGS. 2 and 3, the i-line light 302 diffracts at a first angle 314 that is less than a second angle 406 reached by the h-line light 402.

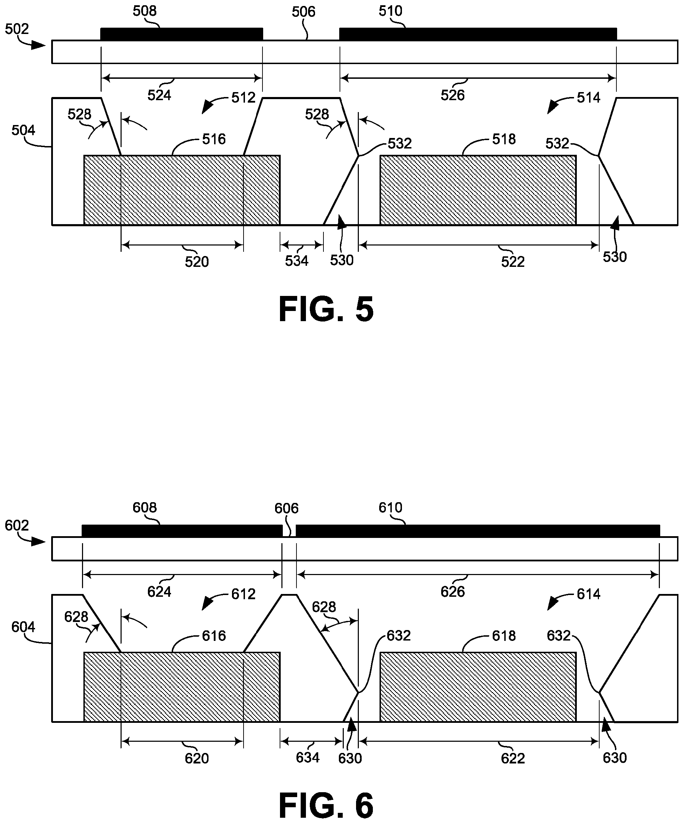

The two differences between the i-line light 302 and the h-line light 402 noted above present advantages and drawbacks for each wavelength of light over the other. In particular, the shallow reach (e.g., relatively small depth) of the i-line light 302 presents limitations in the depth at which the solder resist 304 can be patterned. By contrast, the h-line light 402 extends to a greater depth 404 for more reliable patterning of deeper openings in the solder resist 304. Thus, in terms of the depth of light exposure, the h-line light 402 is generally better than the i-line light 302. On the other hand, the smaller diffraction angle 314 of the i-line light 302 is advantageous over the larger diffraction angle 406 of the h-line light 402 because the smaller angle 314 results in higher resolution in the transfer of a pattern on a mask (e.g., the pattern of opaque material 310 on the photomask 306) to the solder resist 304. The higher resolution means it is possible to create finer features and/or position openings closer together in a solder resist 304 exposed to the i-line light 302 than is possible using h-line light 402. In short, there are trade-offs between the two lines of light 302, 402 with each having advantages over the other. The significance of these advantages (and/or the corresponding disadvantages) are demonstrated with reference to FIGS. 5 and 6.

FIG. 5 shows a photomask 502 that is aligned overtop of a solder resist 504 after being exposed to i-line light (e.g., the i-line light 302 represented in FIG. 3) through the mask 502. FIG. 6 shows another photomask 602 that is aligned overtop of another solder resist 604 after being exposed to h-line light (e.g., the h-line light 402 represented in FIG. 4) through the mask 602. As shown, the photomask 502, 602 in each of FIGS. 5 and 6 includes similar transparent substrates 506, 606 that support respective first and second regions of opaque material 508, 510, 608, 610. The regions of opaque material 508, 510, 608, 610 are aligned with and define the size and shape of corresponding openings 512, 514, 612, 614 in the solder resist 504, 604 generated through the photolithographic process to expose or reveal underlying contact pads 516, 518, 616, 618 (e.g., similar to the contact pads 124 at the base of the solder resist 202 shown in FIG. 2). Specifically, the solder resist 504, 604 is selectively exposed to light (e.g., either the i-line light as in FIG. 5 or the h-line light as in FIG. 6) that passes through the photomask 502, 602 between the regions of opaque material 508, 510, 608, 610. The portions of the solder resist 504, 604 exposed to the light react to the light by hardening relative to the portions not exposed to the light. As a result, when a developer solution is applied to the solder resist 504, 604, the unhardened portions (e.g., portions not exposed to light) are removed while the hardened portions (e.g., portions exposed to light) remain. In other words, the openings 512, 514, 612, 614 correspond to portions of the solder resist 504, 604 that were not exposed to the light. Thus, the differences in the shapes of the openings 512, 514, 612, 614 between FIGS. 5 and 6 is based on the effects of using different wavelengths of light (e.g., either i-line light (FIG. 5) or h-line light (FIG. 6)).

In FIGS. 5 and 6, the first openings 512, 612 (on the left in the figures) are solder mask defined (SMD) openings because an innermost dimension 520, 620 of the first openings 512, 612 in the solder resist 504, 604 corresponds to the critical dimension associated with the extent that the underlying contact pad 516, 616 is exposed. By contrast, the second openings 514, 614 (on the right in the figures) are non-solder mask defined (NSMD) openings because an innermost dimension 522, 622 of the second openings 514, 614 is wider than the associated contact pad 518, 618 (and, thus, does not define the critical dimension corresponding to the size of the contact pad 518, 618).

In FIGS. 5 and 6, the photomasks 502, 602 are constructed so that the innermost dimensions 520, 620 of the first openings 512, 612 are the same and that the innermost dimensions 522, 622 of the second openings 514, 614 are the same. This is achieved by designing the regions of the opaque materials 508, 510, 608, 610 with different dimensions 524, 526, 624, 626 as between FIG. 5 and FIG. 6. Specifically, the dimensions 524, 526 of the opaque materials 508, 510 in FIG. 5 are smaller than the dimensions 624, 626 of the opaque materials 608, 610 in FIG. 6. The dimensions 524, 526 of the opaque materials 508, 510 in FIG. 5 can be smaller than the corresponding dimensions 624, 626 in FIG. 6 and still produce the same innermost dimensions 520, 522, 620, 622 because of the different angles of diffraction 314, 406 of the different wavelengths of light associated with i-line light (FIG. 5) and h-line light (FIG. 6). In particular, the angle of diffraction of light corresponds to the angle 528, 628 of the walls of the respective openings 512, 514, 612, 614 of FIGS. 5 and 6. That is, due to the smaller diffraction angle 314 of the i-line light 302 (used in FIG. 5), there is less difference between the innermost dimension 520, 522 of the openings 512, 514 of FIG. 5 and the uppermost (e.g., top) dimensions at the rim of the openings 512, 514 of FIG. 5 (corresponding to the dimensions 524, 526 of the opaque materials 508, 510) than the difference between the innermost and the uppermost (e.g., top) dimensions of the openings 612, 614 of FIG. 6. As a result, the opaque materials 508, 510 on the photomask 502 of FIG. 5 can be smaller while still achieving the same critical dimension for SMD openings, thereby enabling the openings to be fabricated closer together (e.g., with higher resolution).

While i-line light provides higher resolution for smaller and/or closer features (e.g., openings) than h-line light, a disadvantage of i-line light becomes clear with reference to the NSMD openings 514, 614 (on the right) of FIGS. 5 and 6. As discussed above, i-line light cannot reach deep into the solder resist 504. As a result, only an upper portion of the solder resist 504 is exposed to the light and hardened, while the solder resist material at a greater depth remains soft (unhardened). As a result, when a developer solution is applied and it removes unhardened solder resist down below the depth of the light exposure, the developer solution can begin to eat away or remove the solder resist material directly underneath the hardened solder resist material. As a result, the developer solution can produce an undercut 530 below a protruding inflection point 532 (e.g., an overhang or outcrop) on the sidewall of the second opening 514 in FIG. 5. The protruding inflection point 532 is generally located at the depth 312 reached by the i-line light 302 shown in FIG. 3. The NSMD opening (e.g., the second opening 614) in FIG. 6 is also defined by an undercut 630 below a protruding inflection point 632 on the sidewall of the opening 614. However, the undercut 630 in FIG. 6 is much smaller than the undercut 530 in FIG. 5 because the h-line light (used in FIG. 6) reaches much farther into the solder resist 604 to harden the solder resist material to a greater depth (e.g., down to the inflection point 632) such that there is less solder resist to be removed by a developer solution at locations below the inflection point 632. Significantly, the smaller undercut 630 in FIG. 6 results in a larger extent 634 of the solder resist 604 remaining between the contact pad 618 in the corresponding NSMD opening 614 and the adjacent contact pad 616 than the remaining extent 534 of the solder resist 504 between the contact pads 516, 518 in FIG. 5. The larger extent 634 of the solder resist 604 between the contact pads 616, 618 reduces the likelihood of a short circuit developing and/or enables NSMD openings (e.g., the second opening 614 in FIG. 6) to be positioned closer to adjacent contact pads and/or other electrically conductive components.

Example photomasks disclosed herein enable the advantages of both i-line light (with higher resolution patterns enabling smaller/closer features) and h-line light (that reaches deeper into photoresist materials to reduce the extent of any undercut). Furthermore, examples disclosed herein capture both of these advantages during a single exposure process. That is, both the i-line light and h-line light are applied to a photoresist to be processed (e.g., the solder resist 202, 304, 504, 604 of FIGS. 2-6) at the same time. This is made possible through the addition of an optical filter on regions of a photomask to block, cut, or filter out certain wavelengths of lights at those regions while still permitting other wavelengths at those regions. However, in other regions the optical filter is omitted to permit the wavelengths that were blocked in the first regions due to the optical filter. Further, example photomasks also include regions of opaque material in which no light passes through.

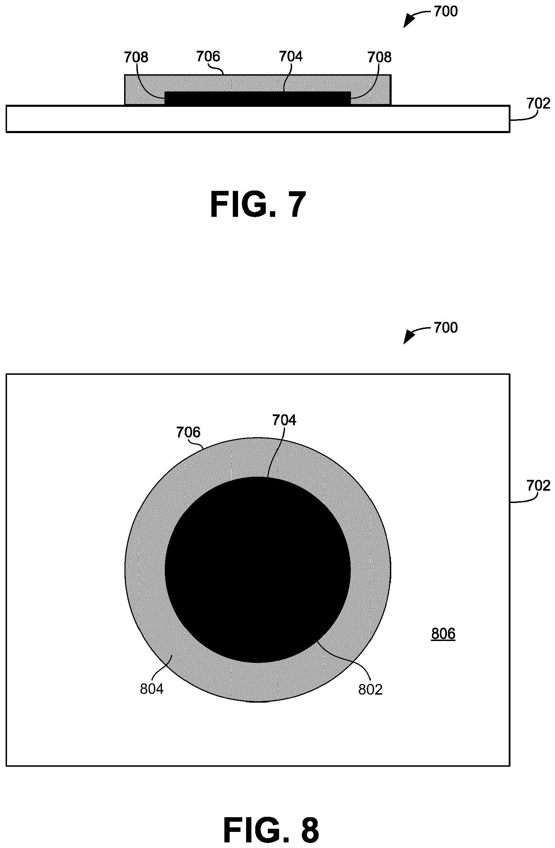

FIG. 7 is a cross-sectional side view of an example photomask 700 constructed in accordance with teachings disclosed herein. The example photomask 700 includes a transparent base or substrate 702 (e.g., a glass panel, a glass pane, a glass sheet) that supports an opaque material 704 similar to the photomask 306, 502, 602 shown in FIGS. 3-6. In some examples, the opaque material 704 is chromium. However, any other opaque material may additionally or alternatively be used.

Unlike the photomasks 306, 502, 602 of FIGS. 3-6, the transparent substrate 702 of the example photomask 700 of FIG. 7 also supports an optical filter 706. As shown in the illustrated example, the optical filter 706 extends over (e.g., extends across) the opaque material 704 such that the opaque material 704 is between the transparent substrate 702 and the optical filter 706. Further, in the illustrated example, the optical filter 706 extends along the side or edge 708 of the opaque material to encase or enclose the opaque material against a surface of the transparent substrate 702. Thus, in some examples, both the opaque material 704 and the optical filter 706 are in contact with the same surface of the transparent substrate 702 such that the opaque material 704 and the optical filter 706 are adjacent one another along the surface of the substrate 702.

FIG. 8 is a bottom view of the example photomask 700 of FIG. 7. Thus, in FIG. 8, both the opaque material 704 and the optical filter 706 are visible through the transparent substrate 702. In this example, the opaque material 704 covers a first area 802 of the transparent substrate 702 and the optical filter 706 covers a second area 804 of the transparent substrate 702. As shown in FIG. 8, the first area 802 has a circular shape with a first diameter and the second area has a circular shape (e.g., an annular ring) with a second diameter that is larger than the first diameter. In this example, the first area 802 is centered with the second area 804 such that the second area surrounds the first area (e.g., the optical filter 706 surrounds the opaque material 704). In some examples, the second area 804 (associated with the optical filter 706) does not completely surround the first area 802 (associated with the opaque material 704) but instead, is adjacent to and/or extends along a portion of the first area 802. While the first and second areas 802, 804 are shown as having a circular shape, which is suitable for creating round openings (e.g., the openings 512, 514, 612, 614 in FIGS. 5 and 6) in an underlying photoresist, one or both of the areas can have any other suitable shape. For instance, in some examples, the first and/or second areas 802, 804 correspond to elongate lines or strips, which may be implemented to pattern elongate trenches in a photoresist. Further, although only one region of the opaque material 704 and one region of the optical filter 706 are shown, any suitable number of regions on the transparent substrate 702 can include one or both of the opaque material 704 and the optical filter 706.

In addition to the first and second areas 802, 804, the example transparent substrate 702 includes a third area 806 that is not covered by the opaque material 704 and is not covered by the optical filter 706. More wavelengths of light are able to pass through the transparent substrate 702 than are able to pass through the optical filter 706, and more wavelengths of light are able to pass through the optical filter 706 than are able to pass through the opaque material 704. In some examples, the opaque material 704 does not permit passage of any wavelength of light (because it is opaque), while all wavelengths of light are able to pass through the transparent substrate 702 (because it is transparent). However, only certain wavelengths are able to pass through the optical filter 706 with other wavelengths being filtered or blocked by the optical filter. Specifically, in this example, the transparent substrate 702 permits passage of both i-line light and h-line light, and the optical filter 706 permits passage of i-line light but filters out h-line light. In other examples, different wavelengths of light are filtered by the optical filter 706.

In some examples, the optical filter 706 is an absorption filter that filters or cuts select wavelengths of light by absorbing the light while allowing other wavelengths to pass through. Absorption filters achieve these optical filtering properties by being colored with a dye selected based on the wavelengths of light to be absorbed and/or transmitted. Such filters can be made from any suitable materials (e.g., glass, polymers, etc.). In other examples, the optical filter 706 is an interference filter (e.g., a dichroic filter) that filters or cuts select wavelengths by reflecting those wavelengths back from a light source while allowing other wavelengths to pass through. Interference filters are implemented by a plurality of thin film layers made of different dielectric and/or metal materials of different refractive indices that create interference for select wavelengths that result in the filtering capability. The particular materials used in an interference filter and/or the design and thickness of the layers depends on the particular wavelengths to be filtered and enabled to pass through the filter.

Inasmuch as the opaque material 704 blocks passage of light, the opaque material 704 is an example means of blocking passage of light. Inasmuch as the optical filter 706 filters light (e.g., blocks some but not all wavelengths of light), the optical filter 706 is an example means of filtering light. Inasmuch as the transparent substrate 702 supports (e.g., carries) both the opaque material 704 and the optical filter 706, the transparent substrate 702 is an example means for supporting the means for filtering adjacent the means for blocking.

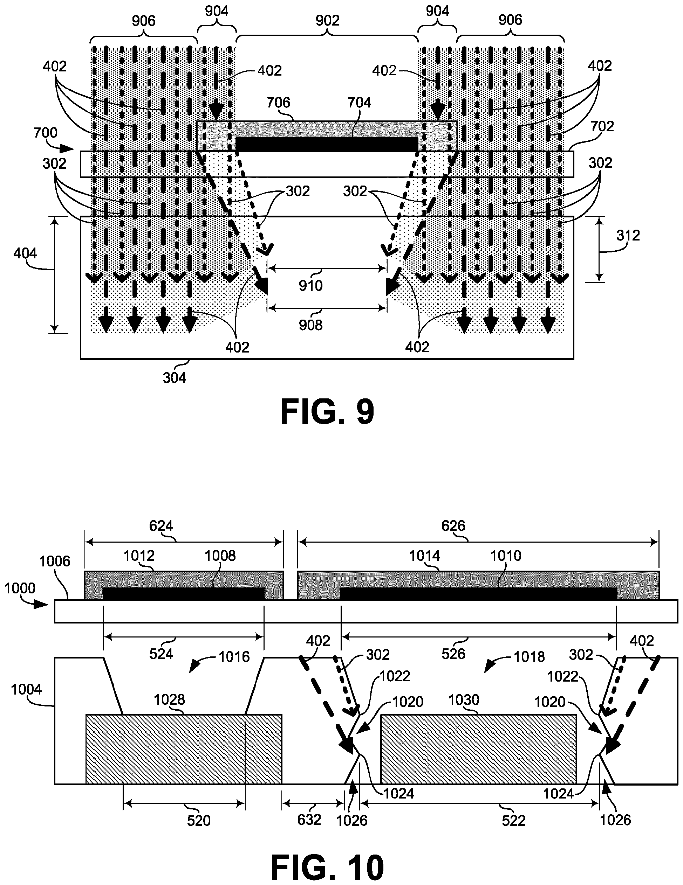

FIG. 9 illustrates the example photomask 700 of FIGS. 7 and 8 being used to pattern the solder resist 304 of FIGS. 3 and 4 with the filtered light 216 of FIG. 2. As discussed above, the filtered light 216 includes both the i-line light 302 and the h-line light 402 shown and described in connection with FIGS. 3 and 4. Thus, FIG. 9 is similar to FIGS. 3 and 4 except that both wavelengths of light are applied to the mask 700 at the same time. As discussed above in connection with FIGS. 3 and 4, for purposes of illustration, the i-line light 302 is represented by light shading and arrows with short broken lines and an open chevron head. By contrast, the h-line light 402 is represented by darker shading and arrows with longer broken lines and a closed triangular head. Areas where both wavelengths are shining are represented by an even darker shading. A first region 902 in FIG. 9 corresponds to the first area 802 of the transparent substrate 702 covered by the opaque material 704 as shown in FIG. 8. As discussed above and represented in FIG. 9, no light passes through the opaque material 704. For purposes of clarity and simplicity, the light incident on (e.g., above) the opaque material 704 is not shown in FIG. 9. A second region 904 (that surrounds the first region 902) corresponds to the second area 804 of the transparent substrate 702 covered by the optical filter 706 as shown in FIG. 8. As discussed above and represented in FIG. 9, the optical filter 706 permits the i-line light 302 to pass through but blocks or filters (either through absorption or reflection/interference) the h-line light 402. Finally, a third region 906 (that surrounds the second region 904) corresponds to the uncovered third area 806 of the transparent substrate 702 as shown in FIG. 8. As discussed above and represented in FIG. 9, both the i-line light 302 and the h-line light 402 are able to pass through the transparent substrate 702 in the third region 904.

Inasmuch as the optical filter 706 permits passage of the i-line light 302, the i-line light 302 passes through the photomask 700 of FIG. 9 in effectively the same way as it would if the optical filter were omitted (as in FIG. 3). That is, the i-line light 302 still extends the first depth 312 into the solder resist 304 and the i-line light 302 still diffracts by the same diffraction angle 314 discussed above in connection with FIG. 3. Further, inasmuch as the optical filter 706 blocks passage of the h-line light 402, the h-line light 402 passes through the photomask 700 of FIG. 9 in effectively the same way as it would if the optical filter were omitted and the opaque material 704 was expanded out to the extent of the optical filter 706. That is, the h-line light 402 still extends the second depth 404 into the solder resist 304 and the h-line light 402 still diffracts by the same diffraction angle 406 discussed above in connection with FIG. 4. However, the starting point of diffraction of the h-line light 402 is shifted outward (to the outer edge of the optical filter 706) relative to the starting point of diffraction of the i-line light 302 (at the outer edge of the opaque material 704). In this example, the amount of this shift (e.g., the amount the optical filter 706 extends beyond the boundary, edge, or perimeter of the opaque material 704) is defined so that the closest dimension 908 between the diffracted portions of the h-line light 402 on opposite sides of the optical filter 706 is approximately the same as the closest dimension 910 between the diffracted portions of the i-line light 302 on opposite sides of the opaque material 704. As a result, exposure with both lights can be implemented simultaneously to achieve the advantages of both wavelengths of light discussed above in connection with FIGS. 5 and 6 as shown in FIG. 10.

FIG. 10 illustrates an example photomask 1000 that is aligned overtop of a solder resist 1004 after being simultaneously exposed to both the i-line light 302 and the h-line light 402 (as represented in FIGS. 3 and 4) through the example mask 1000. The example photomask 1000 of FIGS. 10 is constructed similarly to the photomask 700 of FIG. 9 with a transparent substrate 1006 that supports respective first and second regions of opaque material 1008, 1010 and corresponding optical filters 1012, 1014. In this example, the opaque materials 1008, 1010 are dimensioned similarly to opaque materials 508, 510 in FIG. 5. That is, both first regions of opaque material 508, 1008 in FIGS. 5 and 10 have the same dimension 524 and both second regions of opaque material 510, 1010 in FIGS. 5 and 10 have the same dimension 526. Further, in this example, the optical filters 1012, 1014 are dimensioned similarly to the opaque materials 608, 610 in FIG. 6. That is, both the first opaque material 608 in FIG. 6 and the first optical filter 1012 in FIG. 10 have the same dimension 624 and both the second opaque material 610 in FIG. 6 and the second optical filter 1014 in FIG. 10 have the same dimension 626.

The opaque materials 1008, 1010 and the optical filters 1012, 1014 of FIG. 10 constructed with the dimensions outlined above effectively combine the results of the exposure of the i-line light 302 represented in FIG. 5 with the results of the exposure of the h-line light 402 represented in FIG. 6. In particular, the SMD opening 1016 (on the left in FIG. 10) has the same innermost dimension 520 as the first opening 512 in FIG. 5 with a narrow uppermost (top) dimension at the rim of the opening 1016 corresponding to the dimension 524 of the opaque material 1008. Thus, the higher resolution (for smaller and/or closer features) achieved by the i-line light 302 is achieved. Further, the NSMD opening 1018 (on the right in FIG. 10) is defined by a sidewall with a first undercut 1020 between first and second protruding inflection points 1022, 1024, and a second undercut 1026 below the second (lower) inflection point 1024. In this example, the first (upper) inflection point 1022 is provided by the i-line light 302 similar to the protruding inflection point 532 in FIG. 5. Furthermore, the first undercut 1020 in FIG. 10 is similar to the undercut 530 that develops underneath the corresponding inflection point 532 in FIG. 5. However, the first undercut 1020 does not extend as far in the illustrated example of FIG. 10 than the undercut 530 in FIG. 5 because of the second inflection point 1022 provided by the h-line light 402 similar to the protruding inflection point 632 in FIG. 6. Thus, the second undercut 1026 below the second inflection point 1024 is similar to the undercut 630 in FIG. 6. As a result, the solder resist 1004 extends the same extent 634 between the contact pads 1030, 1032 as the solder resist 604 in FIG. 6, thereby reducing the likelihood of short circuits and/or enabling the contacts pads to be placed closer together as discussed above in connection with FIG. 6. Further, the exposure of the i-line light 302 at the top of the solder resist 1004 at the location corresponding to the outer edges of the opaque material 1010 results in the and the uppermost (e.g., top) dimensions at the rim of the opening 1018 being the same dimension 526 as the opaque material 1010, which is the same dimension 526 as the rim of the opening 514 in FIG. 5. As a result, the upper dimension of the opening 514 is smaller than it would be if only h-line light were used (as shown in FIG. 6), thereby enabling smaller (higher resolution) features that can be positioned closer together.

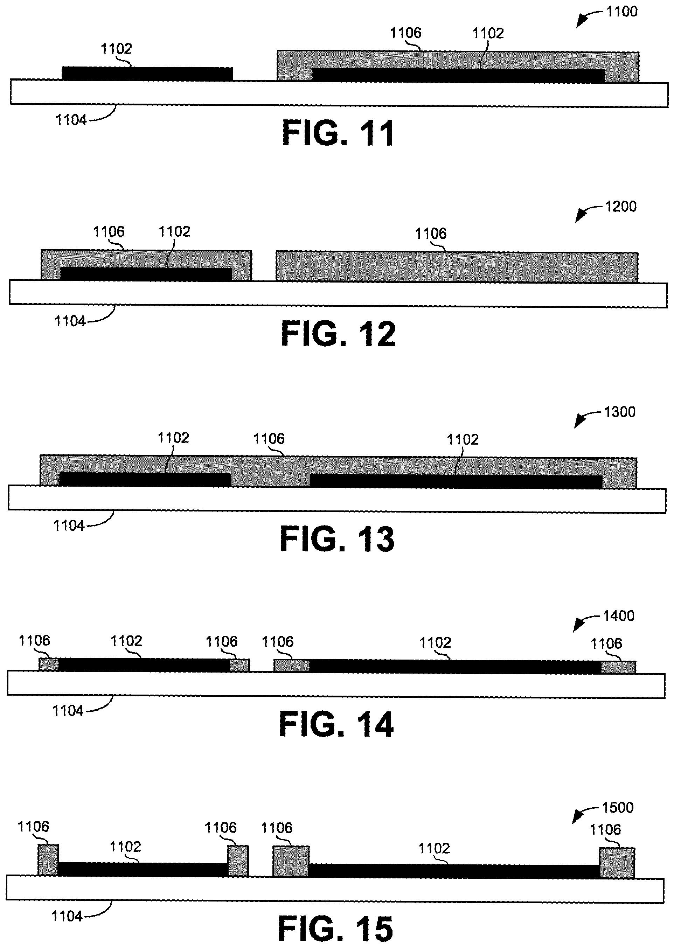

While the example photomasks 700, 1000 of FIGS. 7-10 have been described in detail. Many other implementations are possible. In particular, FIGS. 11-19 illustrate different example photomasks constructed in accordance with teachings disclosed herein. For instance, FIG. 11 illustrates an example photomask 1100 in which two regions of opaque material 1102 are supported on a transparent substrate 1104, but only one of which is surrounded by and/or otherwise adjacent to an optical filter 1106 while the other region of opaque material 1102 is spaced apart from any optical filter 1106. In other words, in some examples, the optical filter 1106 is not necessarily included in connection with every region of opaque material 1102 on the photomask 1100. Similarly, as shown in the example photomask 1200 of FIG. 12, the opaque material 1102 is not necessarily included in connection with every region associated with an optical filter 1106. Specifically, as shown in FIG. 12, the photomask 1200 includes an optical filter 1106 (at the right) that is spaced apart from any opaque material 1102. Further, in some examples, multiple regions of opaque material 1102 can be associated with, adjacent to, covered by, and/or in contact with a single (e.g., unitary) optical filter 1106. For instance, the example photomask 1300 of FIG. 13 includes a single optical filter 1106 that extends continuously between and/or across two adjacent regions of opaque material 1102.

In the foregoing examples, the optical filter 1106 extends overtop of the opaque material 1102 such that the optical filter 1106 (in combination with the transparent substrate 1104) enclose and/or encase the opaque material 1102. However, in some examples, the optical filter 1106 can be spaced apart from a top surface of the opaque material 1102 (e.g., the surface facing away from the transparent substrate 1104) as shown in the illustrated example of FIG. 14. Specifically, the example photomask 1400 of FIG. 14 includes optical filters 1106 that are limited to being lateral adjacent to the outer edges and/or perimeters of the opaque materials 1102. In some examples, the optical filter 1106 partially (but not completely) covers the surface of a corresponding opaque material 1102 facing away from the transparent substrate 1104. In the illustrated example, of FIG. 14, the optical filters 1106 have a thickness approximately equal to thickness of the opaque material 1102. However, the example photomask 1500 of FIG. 15 includes optical filters 1106 that have a thickness greater than the thickness of the opaque material 1102. In other examples, the optical filters 1106 have a thickness that is less than the thickness of the opaque material 1102. In some examples, the thickness of the optical filters 1106 and/or the opaque material 1102 can differ between different locations on the transparent substrate 1104. In some examples, the thickness of an optical filter 1106 is driven by the intended filtering properties of the optical filter 1106. For instance, if the optical filter 1106 is implemented as an absorption filter, the optical filter 1106 may be designed thick enough to adequately absorb the relevant wavelengths to be filtered out during an exposure. Similarly, if the optical filter 1106 is implemented as an interference filter, the optical filter 1106 may be designed with a thickness defined by the number of thin film layers (and their associated thicknesses) to produce the interference effect that results in the relevant wavelengths from being filtered out during an exposure.

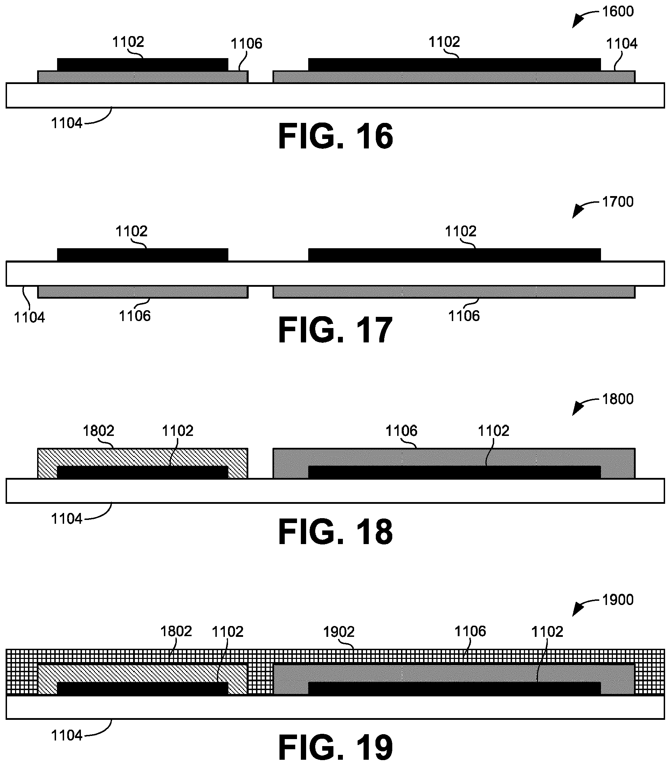

In some examples, the stacked relationship between the transparent substrate 1104, the opaque material 1102, and the optical filter 1106 can differ. For instance, FIG. 16 illustrates another example photomask 1600 in which the optical filter 1106 is between the transparent substrate 1104 and the opaque material 1102. Further, FIG. 17 illustrates another example photomask 1700 in which the opaque material 1102 and the optical filter 1106 are on opposite sides of the transparent substrate 1104 (e.g., the transparent substrate 1104 is between the opaque material 1102 and the optical filter 1106).

In some examples, more than one type of optical filter may be employed on the same transparent substrate to selective filter different wavelengths of light. For instance, FIG. 18 illustrates another example photomask 1800 in which a first region of the opaque material 1102 (at the right) is associated with (e.g., covered by) a first optical filter 1106 that filters out a first wavelength of light (e.g., h-line light). The example photomask 1800 of FIG. 18 further includes a second region of the opaque material 1102 (at the left) that is associated with (e.g., covered by) a second optical filter 1106 that filters out a second wavelength of light different than the first wavelength of light (e.g., i-line light). Additionally or alternatively, in some examples, a separate optical filter can extend across the surface of the transparent substrate 1104 to filter out particular wavelengths across the surface while still permitting others to selectively pass through or be filtered out based on other optical filters. In particular, FIG. 19 illustrates another example photomask 1900 that is identical to the photomask 1800 of FIG. 18 except that a third optical filter 1902 extends continuously across the both the first and second optical filters 1106, 1802 and across exposed portions of the transparent substrate 1104 in the gaps between the first and second optical filters 1106, 1802. In some examples, the third optical filter 1902 can function similarly to the optical filter 208 of FIG. 2 to filter out wavelengths of light that are never intended to reach the underlying substrate to be lithographically processed. Accordingly, in some such examples, the optical filter 208 of FIG. 2 can be omitted.

The foregoing examples of the photomasks 700, 1000, 1100, 1200, 1300, 1400, 1500, 1600, 1700, 1800, 1900 of FIGS. 7-19 teach or suggest different features. Although each example photomask 700, 1000, 1100, 1200, 1300, 1400, 1500, 1600, 1700, 1800, 1900 disclosed above has certain features, it should be understood that it is not necessary for a particular feature of one example to be used exclusively with that example. Instead, any of the features described above and/or depicted in the drawings can be combined with any of the examples, in addition to or in substitution for any of the other features of those examples. One example's features are not mutually exclusive to another example's features. Instead, the scope of this disclosure encompasses any combination of any of the features.

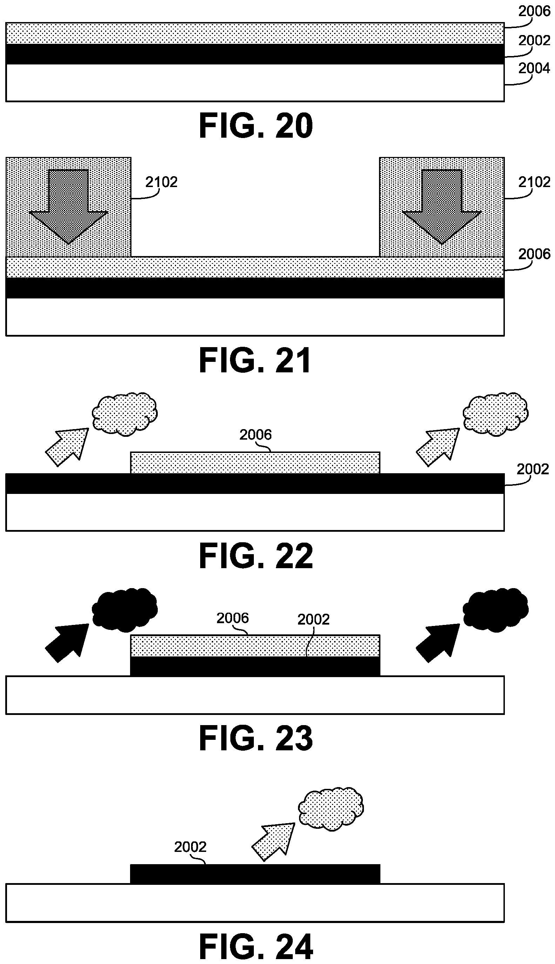

FIGS. 20-24 illustrate example stages in a manufacturing process to add a discrete region of opaque material to a transparent substrate (e.g., a glass panel, a glass pane, a glass sheet). FIG. 20 represents the stage of manufacture after having deposited a layer of the opaque material 2002 onto a transparent substrate 2004 and after having deposited a layer of a photo-sensitive material (e.g., a photoresist) 2006 onto the layer of the opaque material 2002. FIG. 21 represents the selective exposure of the photoresist 2006 to light 2102 (e.g., via a laser). In some examples, the portions of the photoresist 2006 exposed to light 2102 are portions to be removed. FIG. 22 represents the removal (e.g., via a development process) of the portions of the photoresist 2006 exposed to the light 2102, thereby uncovering underlying portions of the opaque material 2002. FIG. 23 represents the removal (e.g., via etching) of the exposed portions of the opaque material 2002. FIG. 24 represents the removal (e.g., via stripping) of the remaining portion of the photoresist 2006, thus revealing the final discrete region of the opaque material 2002. In some examples, the discrete region of the opaque material 2002 corresponds to the opaque material 704 of the example photomask 700 of FIGS. 7 and 8.

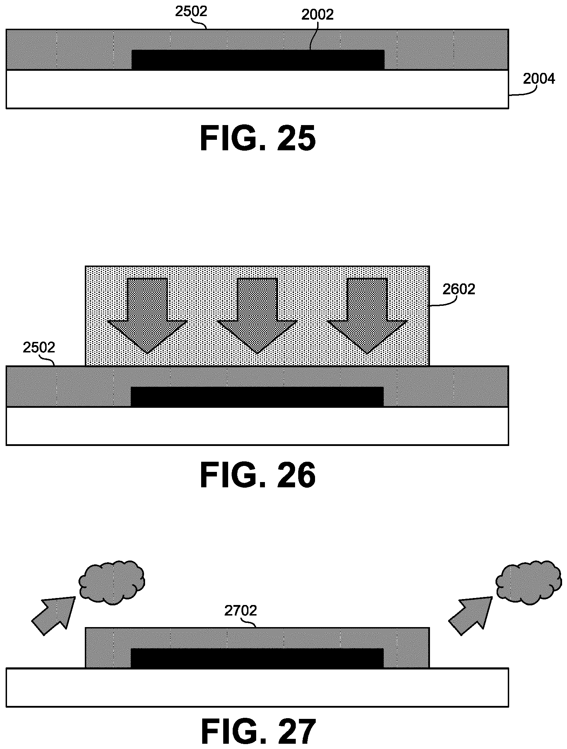

FIGS. 25-27 illustrate example stages in a manufacturing process to add an optical filter adjacent to the discrete region of opaque material 2002 shown in FIG. 24. That is, FIGS. 25-27 are a continuation of the manufacturing process represented in FIGS. 20-24. FIG. 25 represents the depositing (e.g., via vapor deposition (e.g., chemical vapor deposition (CVD), physical vapor deposition (PVD)) and/or any other suitable deposition technique) of a layer of a material 2502 for the optical filter across the transparent substrate 2004 and the discrete region of opaque material 2002. In this example, the layer of material 2502 is a mixture of a light absorption material and a photo-sensitive material. The light absorption material can be any suitable material capable of absorbing light at the particular wavelength(s) to be filtered or cut out. For instance, in some examples, the light absorption material is selected (e.g., by being dyed a suitable color) to absorb h-line light. FIG. 26 represents the selective exposure of the layer of material 2502 to light 2602 (e.g., via a laser). Inasmuch as the layer of material 2502 includes a photo-sensitive material, the layer of material 2502 will react to the light 2602. In this example, the portions of the layer of material 2502 exposed to the light 2602 correspond to the portions of the material 2502 to be retained. FIG. 27 represents the removal (e.g., via a development process) of the portions of the layer of material 2502 not exposed to the light 2102, thereby leaving the portion corresponding to the final optical filter 2702 that is adjacent the opaque material 2002. In some examples, the end result of the manufacturing process represented in FIG. 27 is the example photomask 700 of FIGS. 7 and 8.

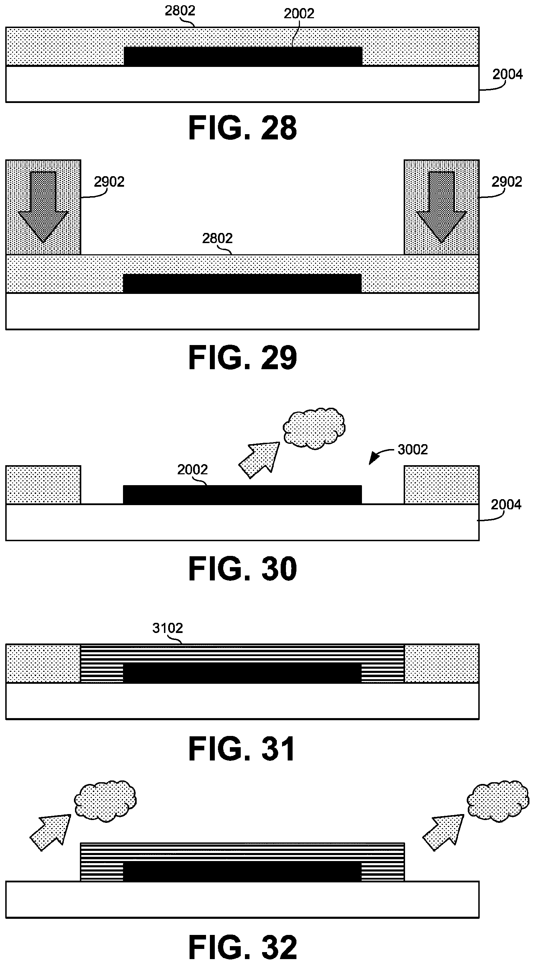

FIGS. 28-32 illustrate alternate example stages in a manufacturing process to add an optical filter adjacent to the discrete region of opaque material 2002 shown in FIG. 24. That is, FIGS. 28-32 are a continuation of the manufacturing process represented in FIGS. 20-24 that may be implemented instead of the process detailed in connection with FIGS. 25-27. FIG. 28 represents the depositing (e.g., via vapor deposition (e.g., chemical vapor deposition (CVD), physical vapor deposition (PVD)), and/or any other suitable deposition technique) of a photoresist 2802 across the transparent substrate 2004 and the discrete region of opaque material 2002. FIG. 29 represents the selective exposure of the photoresist 2802 to light 2902 (e.g., via a laser). In this example, the portions of the photoresist 2802 exposed to light 2902 correspond to portions of the photoresist 2802 to be retained. FIG. 30 represents the removal (e.g., via a development process) of the portions of the photoresist 2802 not exposed to the light 2902, thereby defining an opening 3002 containing the discrete region of the opaque material 2002. As shown in the illustrated example, the opening 3002 is larger than the discrete region of opaque material 2002 so as to reveal portions of the underlying transparent substrate 2004 adjacent to the opaque material 2002. FIG. 31 represents the depositing (e.g., via vapor deposition (e.g., chemical vapor deposition (CVD), physical vapor deposition (PVD)), spattering, and/or any other suitable deposition technique) of multiple thin film layers 3102 to produce an interference filter within the opening 3002. FIG. 32 represents the removal (e.g., via stripping) of the remaining portions of the photoresist 2802 to uncover the transparent substrate 2004. In some examples, the remaining arrangement of thin film layers 3102 correspond to the optical filter 706 of the example photomask 700 of FIGS. 7 and 8.

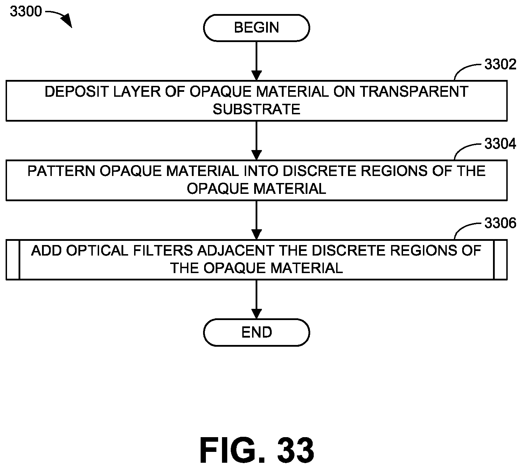

FIGS. 33-35 are flowcharts illustrating example methods of manufacturing the example photomask 700 of FIGS. 7 and 8 and the corresponding photomasks shown in FIGS. 27 and 32. However, the method can be suitable adapted to manufacture any one of the other example photomasks 1000, 1100, 1200, 1300, 1400, 1500, 1600, 1700, 1800, 1900 disclosed herein. In some examples, some or all of the operations outlined in the example methods are performed automatically by fabrication equipment that is programmed to perform the operations. Although the example methods of manufacture are described with reference to the flowcharts illustrated in FIGS. 33-35, many other methods may alternatively be used. For example, the order of execution of the blocks may be changed, and/or some of the blocks described may be combined, divided, rearranged, omitted, eliminated, and/or implemented in any other way.

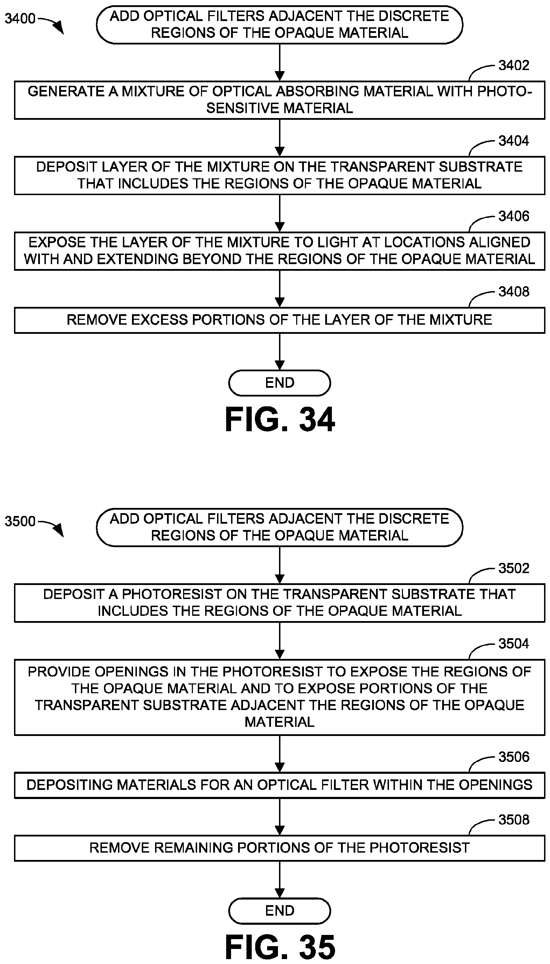

The example method 3300 of FIG. 33 begins at block 3302 by depositing a layer of opaque material (e.g., the opaque material 2002 of FIG. 20) on a transparent substrate (e.g., the transparent substrate 2004 of FIG. 20). At block 3304, the example method involves patterning the opaque material 2002 into discrete regions of opaque material 2002. In some examples, implementation of block 3304 involves the processes detailed in connection with FIGS. 20-24. At block 3306, the example method involves adding optical filters adjacent to the discrete regions of the opaque material 2002. Different methods of implementing block 3306 are detailed further below in connection with each of FIGS. 34 and 35. Specifically, FIG. 34 is a flowchart generally corresponding to the processes detailed in connection with FIGS. 25-27 and FIG. 35 is a flowchart generally corresponding to the processes detailed in connection with FIGS. 28-32.

FIG. 34 is a flowchart representing an example method 3400 to implement block 3306 of FIG. 33. The example method 3400 of FIG. 34 begins at block 3402 by generating a mixture of an optical absorbing material with a photo-sensitive material. At block 3404, the method involves depositing a layer of the mixture on the transparent substrate 2004 that includes the regions of the opaque material 2002 (as represented in FIG. 25). At block 3406, the method involves exposing the layer of the mixture to light at locations aligned with and extending beyond the regions of the opaque material 2002 (as represented in FIG. 26). At block 3408, the method involves removing excess portions of the layer of the mixture (as represented in FIG. 27).

FIG. 35 is a flowchart representing another example method 3500 to implement block 3306 of FIG. 33. The example method 3500 of FIG. 35 begins at block 3502 by depositing a photoresist (e.g., the photoresist 2802 of FIG. 28) on the transparent substrate 2004 that includes the regions of the opaque material 2002. At block 3504, the method involves providing openings (e.g., the opening 3002 of FIG. 30) in the photoresist 2802 to expose the regions of the opaque material 2002 and to expose portions of the transparent substrate 2004 adjacent to the regions of the opaque material 2002 (as represented in FIGS. 29 and 30). At block 3506, the method involves depositing materials for an optical filter within the openings 3002. In some examples, the materials correspond to multiple thin film layers to produce an interference filter (as represented in FIG. 31). In other examples, the openings 3002 can be filled with an absorption material to produce an absorption filter. At block 3508, the method involves removing remaining portions of the photoresist 2802 (as represented in FIG. 32).

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities and/or steps, the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities and/or steps, the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

Notwithstanding the foregoing, in the case of referencing a semiconductor device (e.g., a transistor), a semiconductor die containing a semiconductor device, and/or an integrated circuit (IC) package containing a semiconductor die during fabrication or manufacturing, "above" is not with reference to Earth, but instead is with reference to an underlying substrate on which relevant components are fabricated, assembled, mounted, supported, or otherwise provided. Thus, as used herein and unless otherwise stated or implied from the context, a first component within a semiconductor die (e.g., a transistor or other semiconductor device) is "above" a second component within the semiconductor die when the first component is farther away from a substrate (e.g., a semiconductor wafer) during fabrication/manufacturing than the second component on which the two components are fabricated or otherwise provided. Similarly, unless otherwise stated or implied from the context, a first component within an IC package (e.g., a semiconductor die) is "above" a second component within the IC package during fabrication when the first component is farther away from a printed circuit board (PCB) to which the IC package is to be mounted or attached. It is to be understood that semiconductor devices are often used in orientation different than their orientation during fabrication. Thus, when referring to a semiconductor device (e.g., a transistor), a semiconductor die containing a semiconductor device, and/or an integrated circuit (IC) package containing a semiconductor die during use, the definition of "above" in the preceding paragraph (i.e., the term "above" describes the relationship of two parts relative to Earth) will likely govern based on the usage context.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real world imperfections as will be understood by persons of ordinary skill in the art. For example, "approximately" and "about" may indicate such dimensions may be within a tolerance range of +/- 10% unless otherwise specified in the below description.

As used herein, the phrase "in communication," including variations thereof, encompasses direct communication and/or indirect communication through one or more intermediary components, and does not require direct physical (e.g., wired) communication and/or constant communication, but rather additionally includes selective communication at periodic intervals, scheduled intervals, aperiodic intervals, and/or one-time events.

As used herein, "programmable circuitry" is defined to include (i) one or more special purpose electrical circuits (e.g., an application specific circuit (ASIC)) structured to perform specific operation(s) and including one or more semiconductor-based logic devices (e.g., electrical hardware implemented by one or more transistors), and/or (ii) one or more general purpose semiconductor-based electrical circuits programmable with instructions to perform specific functions(s) and/or operation(s) and including one or more semiconductor-based logic devices (e.g., electrical hardware implemented by one or more transistors). Examples of programmable circuitry include programmable microprocessors such as Central Processor Units (CPUs) that may execute first instructions to perform one or more operations and/or functions, Field Programmable Gate Arrays (FPGAs) that may be programmed with second instructions to cause configuration and/or structuring of the FPGAs to instantiate one or more operations and/or functions corresponding to the first instructions, Graphics Processor Units (GPUs) that may execute first instructions to perform one or more operations and/or functions, Digital Signal Processors (DSPs) that may execute first instructions to perform one or more operations and/or functions, XPUs, Network Processing Units (NPUs) one or more microcontrollers that may execute first instructions to perform one or more operations and/or functions and/or integrated circuits such as Application Specific Integrated Circuits (ASICs). For example, an XPU may be implemented by a heterogeneous computing system including multiple types of programmable circuitry (e.g., one or more FPGAs, one or more CPUs, one or more GPUs, one or more NPUs, one or more DSPs, etc., and/or any combination(s) thereof), and orchestration technology (e.g., application programming interface(s) (API(s)) that may assign computing task(s) to whichever one(s) of the multiple types of programmable circuitry is/are suited and available to perform the computing task(s).

As used herein integrated circuit/circuitry is defined as one or more semiconductor packages containing one or more circuit elements such as transistors, capacitors, inductors, resistors, current paths, diodes, etc. For example an integrated circuit may be implemented as one or more of an ASIC, an FPGA, a chip, a microchip, programmable circuitry, a semiconductor substrate coupling multiple circuit elements, a system on chip (SoC), etc.

From the foregoing, it will be appreciated that example systems, apparatus, articles of manufacture, and methods have been disclosed that incorporate an optical filter into a photomask to enable the selective filtering of certain wavelengths of light through certain regions of the photomask while permitting other wavelengths of light to pass through the photomask. Using multiple wavelengths of light simultaneously enables photolithography processes that capitalize on the advantages of using light with relatively short wavelengths as well as capitalizing on the advantages of using light with relatively long wavelengths. Specifically, shorter wavelengths of light have a smaller diffraction angle and, therefore, have the advantage of enabling higher resolution patterning for smaller and/or closer features. Longer wavelengths of light can reach deeper into a photo-sensitive material (e.g., a solder resist) to reduce the size and associated effects of an undercut developing below the depth of the photo-sensitive material reached by the light. Disclosed systems, apparatus, articles of manufacture, and methods are accordingly directed to one or more improvement(s) in the operation of a machine such as a computer or other electronic and/or mechanical device.

Further examples and combinations thereof include the following:
Example 1 includes a photolithography mask comprising a transparent substrate, an opaque material supported by the transparent substrate, the opaque material covering a first area of the transparent substrate, and an optical filter supported by the transparent substrate, the optical filter covering a second area of the transparent substrate, the second area distinct from the first area, both the opaque material and the optical filter spaced apart from a third area of the transparent substrate.
Example 2 includes the photolithography mask of example 1, wherein the optical filter is directly adjacent to the opaque material along a surface of the transparent substrate.
Example 3 includes the photolithography mask of example 1, wherein the opaque material is between the transparent substrate and the optical filter.
Example 4 includes the photolithography mask of example 1, wherein the optical filter is between the transparent substrate and the opaque material.
Example 5 includes the photolithography mask of example 1, wherein more wavelengths of light are able to pass through the transparent substrate than are able to pass through the optical filter, and more wavelengths of light are able to pass through the optical filter than are able to pass through the opaque material.
Example 6 includes the photolithography mask of example 5, wherein the transparent substrate permits passage of both i-line light and h-line light, and the optical filter permits passage of i-line light but filters out h-line light.
Example 7 includes the photolithography mask of example 1, wherein the first area has a circular shape of a first diameter, and the second area has a circular shape of a second diameter, the second diameter larger than the first diameter, the first area centered with the second area.
Example 8 includes the photolithography mask of example 1, wherein the opaque material has a first thickness, and the optical filter has a second thickness, the second thickness greater than the first thickness.
Example 9 includes the photolithography mask of example 1, wherein the transparent substrate permits passage of light including a first wavelength and a second wavelength, the optical filter to permit passage of a first portion of light corresponding to the first wavelength and to filter a second portion of the light corresponding to the second wavelength, the first wavelength approximately 365 nanometers, the second wavelength approximately 405 nanometers.
Example 10 includes the photolithography mask of example 1, wherein the optical filter is an interference filter.
Example 11 includes the photolithography mask of example 1, wherein the optical filter is an absorption filter.
Example 12 includes the photolithography mask of example 1, wherein the opaque material is on a first side of the transparent substrate, and the optical filter is on a second side of the transparent substrate, the first side opposite the second side.
Example 13 includes a photolithography mask comprising means for blocking passage of light, means for filtering the light, and means for supporting the means for filtering adjacent the means for blocking, a portion of the means for supporting to be spaced apart from the means for blocking and spaced apart from the means for filtering.
Example 14 includes the photolithography mask of example 13, wherein the means for filtering is in contact with an edge of the means for blocking.
Example 15 includes the photolithography mask of example 13, wherein the means for filtering encloses the means for blocking against a surface of the means for supporting.
Example 16 includes the photolithography mask of example 13, wherein the portion of the means for supporting to permit passage of light filtered by the means for filtering, the means for filtering to permit passage of light blocked by the means for blocking.
Example 17 includes a method for manufacturing a photolithography mask, the method comprising depositing an opaque material on a glass panel, and providing an optical filter on the glass panel, the optical filter to extend outward from an edge of the opaque material, the glass panel to extend beyond an edge of the optical filter.
Example 18 includes the method of example 17, wherein the providing of the optical filter on the glass panel includes depositing a material for the optical filter overtop of the opaque material.
Example 19 includes the method of example 17, further including generating a mixture of an optical absorbing material with a photo-sensitive material, depositing the mixture on the glass panel over the opaque material, lithographically patterning the mixture to define a first portion of the mixture to be retained and a second portion of the mixture to be removed, the first portion aligned with and extending beyond the opaque material, and removing the second portion of the mixture.
Example 20 includes the method of example 17, further including depositing a photoresist on the glass panel over the opaque material, providing an opening in the photoresist to expose the opaque material and to expose a portion of the glass panel adjacent to the opaque material, and providing the optical filter by depositing a plurality of thin film layers into the opening, the plurality of thin film layers to implement an interference filter.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. A photolithography mask comprising:
a transparent substrate;
an opaque material supported by the transparent substrate, the opaque material covering a first area of the transparent substrate; and
an optical filter supported by the transparent substrate, the optical filter covering a second area of the transparent substrate, the second area distinct from the first area, both the opaque material and the optical filter spaced apart from a third area of the transparent substrate.

2. The photolithography mask of claim 1, wherein the optical filter is directly adjacent to the opaque material along a surface of the transparent substrate.

3. The photolithography mask of any one of claims 1 or 2, wherein the opaque material is between the transparent substrate and the optical filter.

4. The photolithography mask of any one of claims 1 or 2, wherein the optical filter is between the transparent substrate and the opaque material.

5. The photolithography mask of any one of claims 1-4, wherein more wavelengths of light are able to pass through the transparent substrate than are able to pass through the optical filter, and more wavelengths of light are able to pass through the optical filter than are able to pass through the opaque material.

6. The photolithography mask of claim 5, wherein the transparent substrate permits passage of both i-line light and h-line light, and the optical filter permits passage of i-line light but filters out h-line light.

7. The photolithography mask of any one of claims 1-6, wherein the first area has a circular shape of a first diameter, and the second area has a circular shape of a second diameter, the second diameter larger than the first diameter, the first area centered with the second area.

8. The photolithography mask of any one of claims 1-7, wherein the opaque material has a first thickness, and the optical filter has a second thickness, the second thickness greater than the first thickness.

9. The photolithography mask of any one of claims 1-8, wherein the transparent substrate permits passage of light including a first wavelength and a second wavelength, the optical filter to permit passage of a first portion of light corresponding to the first wavelength and to filter a second portion of the light corresponding to the second wavelength, the first wavelength approximately 365 nanometers, the second wavelength approximately 405 nanometers.

10. The photolithography mask of any one of claims 1-9, wherein the optical filter is an interference filter.

11. The photolithography mask of any one of claims 1-9, wherein the optical filter is an absorption filter.

12. The photolithography mask of any one of claims 1, 2, or 5-11, wherein the opaque material is on a first side of the transparent substrate, and the optical filter is on a second side of the transparent substrate, the first side opposite the second side.

13. A method for manufacturing a photolithography mask, the method comprising:
depositing an opaque material on a glass panel; and
providing an optical filter on the glass panel, the optical filter to extend outward from an edge of the opaque material, the glass panel to extend beyond an edge of the optical filter.

14. The method of claim 13, wherein the providing of the optical filter on the glass panel includes depositing a material for the optical filter overtop of the opaque material.

15. The method of any one of claims 13 or 14, further including:
generating a mixture of an optical absorbing material with a photo-sensitive material;
depositing the mixture on the glass panel over the opaque material;
lithographically patterning the mixture to define a first portion of the mixture to be retained and a second portion of the mixture to be removed, the first portion aligned with and extending beyond the opaque material; and
removing the second portion of the mixture.
